# EUROPEAN PATENT SPECIFICATION

(11) **EP 0 389 683 B1**
(45) Date of publication and mention of the grant of the patent: **01.02.1995**
(21) Application number: 89122337.2
(22) Date of filing: 04.12.1989
(51) Int. Cl.: G01R 31/28

(54) **Apparatus and method for regulating a measurement system**
Apparat und Verfahren zur Regelung einer Messanordnung
Appareil et procédé pour régler un dispositif de mesure

(30) Priority: 29.03.1989 US 331419
(43) Date of publication of application: 03.10.1990
(73) Proprietor: Hewlett-Packard Company, Palo Alto, California 94304 (US)
(72) Inventor: Eidson, John C., Palo Alto California 94303 (US)
(74) Representative: Liesegang, Roland, Dr.-Ing.

(56) References cited:
- EP-A- 0 296 884
- AUTOTESTCON '89 CONFERENCE RECORD, Philadelphia, PA, 25th - 28th September1989, pages 217-224; K. CHIPPERFIELD: "Exploring VXIbus systems andinstrumentation
- IDEM
- PATENT ABSTRACTS OF JAPAN, vol. 7, no. 78 (P-188)[1223], 31st March 1983;& JP-A-58 9077 (TOKYO SHIBAURA DENKI K.K.) 19-01-1983
- ELECTRICAL DESIGN NEWS, vol. 28, no. 9, April 1983, pages 191-195, Boston, MA,US; S. Den Beste: "Crack tough system problems with a dual-timebase analyzer"

## Description

### BACKGROUND OF THE INVENTION

The present invention relates generally to electronic measurement systems, and more particularly, to a method and apparatus for controlling automatic measurement systems using real-time clocks and data buffers. Unlike conventional devices which rely upon a central computer to issue complex interrupts and messages that command an instrument to gather and dispatch data to and from a device under test, the present invention uses a real-time clock and a data buffer to manage the process autonomously and simplify the entire measurement operation. Measurement system control using real-time clocks and data buffers provides an accurate, reliable, and cost effective method that can be used to coordinate the operation of a wide variety of diagnostic, stimulus, and monitoring instruments.

Complex instruments often require complicated coordination instructions from a central computer. When, for example, integrated circuits are fabricated in a chemical vapor deposition chamber, the temperature, pressure, and gaseous contents of the interior of the chamber are usually carefully regulated and monitored by a computer. This computer uses a program of instructions that contains many lines of software code to command actuators and valves to supply reactants to the chamber on a precise schedule.

The software code that is typically employed to provide the timing control for one or more instruments that gather data from or provide data to a device under test is generally tedious to compose, susceptible to errors, and often difficult to decipher by persons other than the author. The code is usually written in a simple programming language such as BASIC.

One problem created by using a central computer to manage the operation of one or many instruments via software utilizing interrupts or messages is the difficulty of making changes or improvements. Each time a new or different measurement or procedure is added, a voluminous listing of software instructions must be reviewed, rewritten, and re-entered into the memory of the central computer. Some additions or revisions may not be permitted by the constraints attributable to the hardware, network facility, or operating system that runs the applications programs on the computer. Other difficulties such as timing incompatibilities are encountered when the computer is modified or upgraded. If additional instruments are added to the system to make more measurements, the enlargement of the network can cause propagation delays that impair communications throughout the system. Another shortcoming of utilizing a central computer to handle all aspects of the operation of several instruments is the loss or confusion of output data. Once the computer has commanded the various instruments to collect information about an object or a device under test and the resulting instrument output signals are reported back to the central computer in accordance with its instructions, some data may arrive out of order or may be missing, and therefore ruin the measurements. Perhaps the greatest deficiency of present centralized timing control systems is their inefficient use of computer power. Since the central command computer must be intimately involved in the real-time control of the instruments and in dispatching data, the central computer remains in an unproductive waiting mode during a large segment of the operation.

A proposed solution to the problem is to interpose a special-purpose computer between the central computer and the measuring instruments. For example, in European Patent Application no. 0,296,884 titled "Method and Apparatus for In-Circuit Testing of Electronic Devices", filed by Schlumberger Technologies, Inc. on June 23, 1988, a "test sequence controller 68" receives instruction from a general-purpose "test controller 60" computer such as an IBM PC and in turn controls a plurality of "driver/sensor board 72" measuring instruments. The test sequence controller has its own "intelligence" and memory - - in other words, it is itself a computer -- such that it can perform a testing sequence, store the results, and send the results back to the control computer when the test is completed. This solution improves throughput and facilitates debugging in its intended environment of a system for testing integrated circuit chips that are installed in a complete circuit, but it still uses a centralized test sequence controller. Thus, this proposed system still does not adequately solve the problems of inefficient use of the central test sequence controller, centralized timing control, data arriving out-of-sequence at the test sequence controller, and modifying the system to add new kinds of measurements other than those for which the pre-existing driver/sensor boards have been designed.

The problem of providing a reliable and efficient measurement control system that avoids the shortcomings recited above has presented a major challenge to designers in the field of computer operated instrumentation systems. The development of a method and an apparatus that is flexible, easy to upgrade, allows for the addition of new instruments to an old network, and which better utilizes the resources of a control computer would constitute a major technological advance in the instrumentation business. The enhanced performance that could be achieved using such an innovative device would satisfy a long felt need within the industry and would enable both manufacturers and users of complex measurement devices to save substantial expenditures of time and money.

To solve the above problem the present invention provides a measurement system according to claim 1 and a method of controlling measurement instruments according to claim 5.

### SUMMARY OF THE INVENTION

The Measurement System Control methods and apparatus which are disclosed and claimed in this patent application overcome the problems of inefficiency, programming difficulty, and hardware configuration constraints that are encountered when central control computers are employed to regulate instrumentation systems using interrupts or messages. The enhanced performance that is achieved using the present invention is due to the placement of a real-time synchronized clock and a data buffer on each instrument or device in the system that performs a measurement, provides a stimulus, controls some device, manages data, or performs a test. Instead of employing a central computer to provide centralized timing control commands to each instrument, instructions transmitted from a coordinating computer are stored on-board each instrument in a data buffer and operations based upon these instructions are executed when the instrument receives activation signals from a local real-time clock. This method and apparatus greatly enhance the flexibility and productivity of the system. Since the coordinating computer does not depend upon a centralized list of software instructions that are issued in a particular sequence to achieve timing control, the software code, language, and hardware may be upgraded or modified with little difficulty. Additional instruments may be added to a network of existing instruments easily, since there is no central timing scheme that would be disturbed by this expansion of system elements. The efficiency of the coordinating computer system is far greater in comparison to a control computer that handles each process step using interrupts or message passing, because the instruments function autonomously, without need for direct control. The present invention also solves the problem of the confusion of instrument output signals by associating a reference time supplied by the real-time clock with each group of instrument output data. In effect, this feature provides a time stamp for each piece of information produced by the system so that the order of information that describes the device or object under test is never in doubt, despite propagation delays or sequence changes that may be inherent in the network or in other systems, components, or software. This time stamp facility also enables an instrument to collect and to mark data without requiring pre-programming that would instruct the instrument about which data should be retained. The marked data can be selected at a later time based upon the time stamps and upon the interpretation of a message containing a reference time stamp, such as the time of some event which is external to the instrument.

Unlike a central computer which initiates and manages each operation of an instrument which it controls, the coordinating computer issues instructions based upon a program stored in its memory. This instruction is stored within an instrument in a data buffer. The instruction generally includes two components: a description of an operation that must be performed, and a specified time for its performance. A real-time clock supplies the instrument with the correct time so that it can execute its instructions from the coordinator on schedule. When the real time clock informs the instrument that an appropriate event time has been realized, the instrument will be activated and will perform the measurement or action dictated by the instructions which reside in its data buffer. After the measurement is made and an output signal from a device under test is collected by the instrument, the real-time clock supplies a reference time signal which is associated with each output signal or group of data derived from the device under test. By matching data with reference times and storing the data in an on-board buffer, the results of the measurement are preserved in their proper order and may be transferred to the coordinating computer or to some other device at some more convenient future time.

The Measurement System Control invention is an innovative method and apparatus that provides an effective and powerful tool which will enable engineers in the electronics industry to construct complex instrumentation networks that are more productive and flexible than currently available systems.

An appreciation of other aims and objectives of the present invention and a more complete and comprehensive understanding of this invention may be achieved by studying the following description of a preferred embodiment and by referring to the accompanying drawings.

### BRIEF DESCRIPTION OF THE DRAWINGS

Figure 1 is a block diagram of the apparatus which is used to implement Measurement System Control Using Real-Time Clocks and Data Buffers; and
Figure 2 is a block diagram of various instruments that are coordinated in accordance with the inventor's method.

### DETAILED DESCRIPTION OF A PREFERRED EMBODIMENT

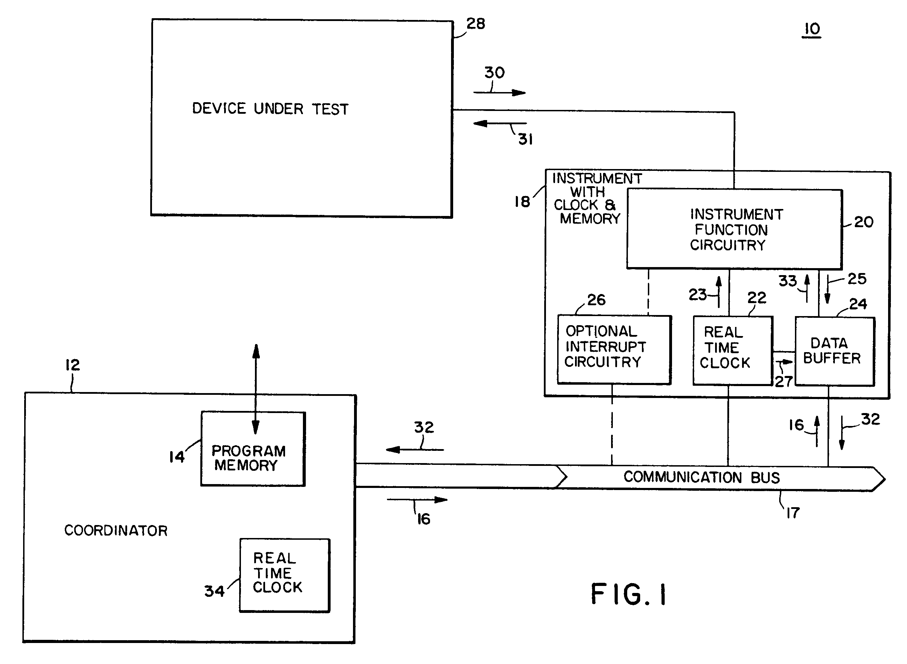

Figure 1 is a schematic block diagram which depicts a Measurement System Controller 10. The system includes a coordinator 12 that transmits instruction signals 16 based upon a program stored in a memory 14 to an instrument 18 through a communication bus 17. The coordinator 12 is generally a computer which is able to issue a set of instructions, but the term "coordinator" is employed here as a generic term that encompasses any device which is capable of storing or generating instructions and disseminating them into a network. The term "set of instructions" refers to any number of commands, including one. The instrument 18 is coupled to the communication bus 17. The instrument 18 is shown as a single unit that includes function circuitry 20, a real-time synchronized clock 22, a data buffer 24, and optional interrupt circuitry 26. Instrument 18 is also coupled to a device under test 28. In this application, the term "device under test" refers to any apparatus, object, or environment about which an instrument gathers information, makes measurements, or provides a stimulus. Signals 30 and 31 passing between the device under test 28 and the instrument 18 are processed by function circuitry 20. The coordinator 12 will generally contain a real-time clock 34 so that the coordinator 12 can synchronize its internal operation with the remainder of the system and can generate instructions for the instrument 18.

Unlike a central computer which initiates and manages each operation of an instrument which it controls, the coordinator 12 issues instructions based upon a program stored in its memory 14 in the form of a signal 16. This instruction signal 16 propagates along the communication bus 17 and is stored within instrument 18 in data buffer 24. This input is read by the function circuitry 20 as a signal 33 that emanates from data buffer 24. The instruction signal 16 generally includes two components: a description of an operation that must be performed, and a specified time for its performance. For example, the gist of one typical instruction signal 16 might be: Measure the voltage present at the output of the device under test at 10:00 a.m. The real-time clock 22 supplies the instrument 18 with the correct time so that it can execute its stored copy of instructions 16 from the coordinator 12 on schedule. When the real time clock 22 informs the instrument 18 that the time is 10:00 a.m., the instrument 18 will be activated and will perform the measurement dictated by the instruction signals 16 which reside in its data buffer 24. The input of the correct time from the real-time clock 22 to the function circuitry 20 of the instrument 18 can be thought of as an activation time signal 23 which provides the timing control that would otherwise be accomplished by the optional interrupt circuitry 26 acting on particular interrupt commands or messages from a central computer. Alter the measurement is made and a parameter or an output signal 30 from the device under test 28 is collected by the instrument 18, the real-time clock 22 supplies a reference time signal 27 which is associated with each output signal 30 or group of data derived from the device under test 28. The data buffer 24 stores each group of data 30 with its associated reference time signal 27 until the coordinator 12 calls for the instrument 18 to dispatch the results of the measurement 30 or stimulus 31 back along the communication bus 17 in the form of an instrument output signal 32. If the instrument 18 provides a stimulus 31 to the device under test 28, the stimulus appears as an input signal 31 in accordance with the instruction signal 16 which has been stored in data buffer 24. The stimulus 31 is triggered by a timing signal 23 from the real-time clock 22.

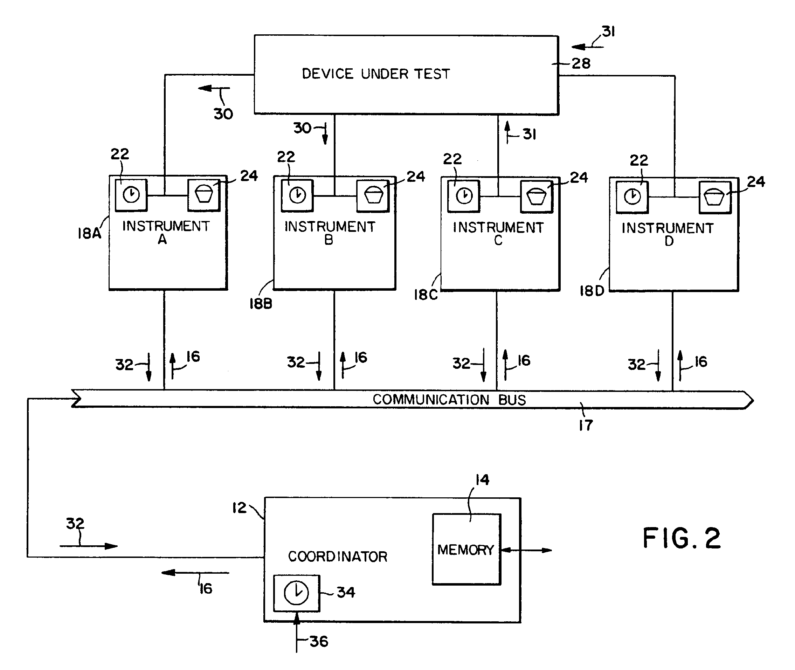

Figure 2 expands upon the arrangement shown in Figure 1 to show the same relative configuration for the case of multiple instruments. Some of the components illustrated in Figure 2 are similar to components shown in Figure 1, and for convenience such components have been assigned the same reference numerals as the corresponding components in Figure 1. In Figure 2, four instruments 18A, 18B, 18C and 18D are each regulated by coordinator 12. 18A and 18B represent instruments which perform measurements, while 18C and 18D represent instruments that supply stimuli to a device 28 under test. Any number of instruments such as the instruments 18A through 18D may be coordinated using the method and apparatus of the present invention that is disclosed and claimed in this patent application.

One great advantage provided by using real-time clocks 22 is the avoidance of transmission delays that might otherwise disrupt a system that is connected across a network. If a central computer is employed to provide timing control by sending interrupt signals to instruments, the transmission delays cause skew in the event synchronization which can compromise the significance of the measurements 30 and stimuli 31. When real-time synchronized clocks associated with each instrument are used to regulate the scheduling of the system, the skew is a function of clock synchronization rather than any variation in the transmission media. This skew is easier to calibrate and can be limited by maintaining a highly accurate synchronization among all the clocks in the system.

The real-time clocks 22 must be sufficiently precise and stable to provide reliable timing control. Commonly available devices easily achieve stabilities of one part in a billion. This rate accuracy is adequate to maintain two 1 MHz systems in synchronization to an accuracy of one microsecond for a period of approximately ten minutes. The degree of difficulty encountered in synchronizing the clocks depends upon the accuracy requirements and the nature of the transmission media that is employed. Techniques for synchronizing clocks using an external timing signal 36 are described in the literature. These techniques generally involve the exchange of messages containing the local time of the sender among the various clocks of the system. Persons ordinarily skilled in the art are capable of using these messages and the algorithms to synchronize clocks to a degree of accuracy that is required to practice the present invention.

The incorporation of a data buffer 24 on each instrument 18 allows the coordinator 12 to retrieve the results of a measurement 32 that are stored in the buffer 24 at a time which may be much later than the time at which the measurement was actually made. This technique enables the user of the system to "reach back in time" and observe measurements that were made previously. The method is limited only by the storage capacity of the data buffer 24 and by the required time resolution between reference time values 27 that are associated with each group of data 30 or 31 collected by the instrument 18. The data buffer 24 may be partitioned in many ways, including, but not limited to, separate sections for instruction signals 16 and output signals 32. The buffer 24 may also be partitioned on the basis of time periods established by the real-time clock 22 via signal 27. A third alternative would be to partition the buffer 24 into sections for static and dynamically changing data.

Another beneficial consequence of implementing the methods prescribed by the present invention is that the choice of the communication bus 17 is far less critical than in the case of using a central computer transmitting interrupts or messages to accomplish timing control. With some minor modifications, the present invention may be practiced on a GP-IB Network, Local Area Network, or other similar communication media.

The present invention may also be utilized when the measurement process must be initiated by some external event that can not be scheduled in advance. This is accomplished by transmitting a control signal to all system resources. This control signal would be generated by the instrument that detects the external event. This signal would contain the time of the external event as established by a real-time clock. When another instrument receives this time value imbedded in the control signal, the received time value is compared to the time indicated by the real-time clock on-board the receiving instrument. The appropriate operations or procedures are then executed in accordance with the instructions held in a data buffer on the receiving instrument.

Measurement System Control Using Real-Time Clocks and Data Buffers provides an accurate and powerful improvement for a wide variety of instrumentation systems. This invention constitutes a major step forward in the continually evolving field of electronic test and measurement.

Although the present invention has been described in detail with reference to a particular preferred embodiment, persons possessing ordinary skill in the art to which this invention pertains will appreciate that various modifications and enhancements may be made without departing from the scope of the claims that follow.

## Claims

1. A measurement system including a coordination means (12) and a plurality of measurement instruments (18A, 18B) remotely located from each other and from the coordination means (12), the coordination means (12) operative to transmit control instructions to different ones of the measurement instruments (18A, 18B), the measurement instruments (18A, 18B) responsive to the control instructions to perform measurements on a device (28) under test and to transmit results of those measurements to the coordination means (12), characterized by:
a local real-time synchronized clock (22) in each of the measurement instruments (18A, 18B) for providing a timing signal;
a local buffer (24) in each of the measurement instruments (18A, 18B) for storing the respective control instructions and the measurement results; local instrument function circuitry (20) in each of the measurement instruments (18A, 18B), said circuitry being responsive to the respective control instruction in the respective local buffer (24) to perform the measurement specified by the control instruction when the respective local clock (22) activates the local circuitry (20) at a time specified by the control instruction and to store the result of the measurement in the respective local buffer (22).

2. A system as in claim 1 wherein the time specified by the control instruction is determined relative to a time at which a specified event occurs.

3. A system as in claim 2 and further comprising a third measurement instrument (18C) having a local real-time synchronized clock (22), the third measurement instrument (18C) operative to detect occurrence of the specified event and to transmit the time of the occurrence as indicated by its local clock to the other measurement instruments (18A, 18B), at least one of said other measurement instrument (18A, 18B) operative to perform the measurement specified by the control instruction when the respective local clock (22) indicates that the specified time as determined relative to the time of occurrence of the specified event is at hand.

4. A system as in claim 3 and further comprising means (34) for synchronizing the local clocks (22).

5. A method of controlling measurement instruments (18A, 18B) in a system having a coordination means (12) that transmits control instructions to different ones of a plurality of said measurement instruments (18A, 18B) remotely located from each other and from the coordination means (12), each of the measurement instruments (18A, 18B) responsive to control instructions to perform measurements on a device (28) under test and to transmit the result of those measurements back to the coordination means (12), characterized by:
transmitting from the coordination means (12) a control instruction that specifies a measurement to be performed and a time at which the measurement is to be performed;
storing the control instruction in a local buffer (24) in that measurement instrument (18A, 18B) which is to perform the measurement;
performing the measurement specified by the control instruction when a real-time synchronized local clock (22) in that measurement instrument (18A, 18B) which is to perform the measurement indicates that the time at which the measurement is to be performed is at hand; and
storing the result of the measurement in said local buffer (24).

6. A method as in claim 5 wherein the time specified by the control instruction is determined relative to a time at which a specified event occurs.

7. A method as in claim 6 and further comprising:
detecting the time of occurrence of the specified event by means of a real-time synchronized local clock (22) in a third measurement instrument (18C);
transmitting said time of occurrence; and
performing the measurement when the local clock (22) in that measurement instrument (18A, 18B) which is to perform the measurement instrument indicates that the time at which the measurement is to be performed, as determined relative to the time of the occurrence of the specified event, is at hand.

8. A method as in claim 7 and further comprising synchronizing the local clocks (22) in the measurement Instruments (18A, 18B, 18C).

## Patentansprüche

1. Meßsystem, mit einer Koordinationsvorrichtung (12) und mehreren Meßgeräten (18A, 18B), welche entfernt voneinander und entfernt von der Koordinationsvorrichtung (12) angeordnet sind, wobei die Koordinationsvorrichtung (12) Steuerbefehle an unterschiedliche Meßgeräte (18A, 18B) übertragen kann, die Meßgeräte (18A, 18B) auf die Steuerbefehle ansprechen, um Messungen an einer zu prüfenden Vorrichtung (28) durchzuführen und Ergebnisse dieser Messungen an die Koordinationsvorrichtung (12) zu übertragen,
**gekennzeichnet** durch
eine lokale, zur Realzeit synchronisierte Uhr (22) in jedem der Meßgeräte (18A, 18B) zum Vorsehen eines Zeitsignales,
einen lokalen Puffer (24) in jedem der Meßgeräte (18a, 18b) zum Speichern der jeweiligen Steuerbefehle und der Meßergebnisse,
einer lokalen Gerätefunktionsschaltung (20) in jedem der Meßgeräte (18a, 18b), wobei die Schaltung auf den jeweiligen Steuerbefehl in dem jeweiligen lokalen Puffer (24) anspricht, um die durch den Steuerbefehl spezifizierte Messung durchzuführen, wenn die jeweilige lokale Uhr (22) die lokale Schaltung (20) zu einem Zeitpunkt aktiviert, welcher durch den Steuerbefehl spezifiziert wird, und um das Ergebnis der Messung in dem jeweiligen lokalen Puffer (24) zu speichern.

2. System nach Anspruch 1, bei dem die durch den Steuerbefehl spezifizierte Zeit relativ zu einem Zeitpunkt bestimmt wird, zu dem ein bestimmtes Ereignis auftritt.

3. System nach Anspruch 2, mit weiterhin einem dritten Meßgerät (18C) mit einer lokalen, zur Realzeit synchronisierten Uhr (22), wobei das dritte Meßgerät (18C) das Auftreten des bestimmten Ereignisses erfassen kann und den Zeitpunkt seines Auftretens, der durch seine lokale Uhr angezeigt wird, an die anderen Meßgeräte (18A, 18B) übertragen kann, wobei mindestens eines der anderen Meßgeräte (18A, 18B) die durch den Steuerbefehl spezifizierte Messung durchführen kann, wenn die jeweilige lokale Uhr (22) anzeigt, daß die spezifizierte Zeit, welche relativ zum Zeitpunkt des Auftretens des bestimmten Ereignisses bestimmt wird, gekommen ist.

4. System nach Anspruch 3, mit weiterhin einer Vorrichtung (34) zum Synchronisieren der lokalen Uhren (22).

5. Verfahren zum Steuern von Meßgeräten (18A, 18B) in einem System mit einer Koordinationsvorrichtung (12), welche Steuerbefehle zu verschiedenen von einer Vielzahl von solchen Meßgeräten (18A, 18B) überträgt, die entfernt voneinander und entfernt von der Koordinationsvorrichtung (12) angeordnet sind, wobei jedes der Meßgeräte (18A, 18B) auf Steuerbefehle anspricht, um Messungen an einer zu prüfenden Vorrichtung (28) durchzuführen und das Ergebnis dieser Messungen zur Koordinationsvorrichtung (12) zurückzuübertragen, **gekennzeichnet** durch Übertragen eines Steuerbefehls von der Koordinationsvorrichtung (12), der eine durchzuführende Messung und eine Zeit, zu der die Messung durchgeführt werden soll, spezifiziert,
Speichern des Steuerbefehl in einem lokalen Puffer (24) in dem Meßgerät (18A, 18B), welches die Messung durchführen soll,
Durchführen der durch den Steuerbefehl spezifizierten Messung, wenn eine lokale, zur Realzeit synchronisierte Uhr (22) in dem Meßgerät (18A, 18B), welches die Messung durchführen soll, anzeigt, daß die Zeit, zu der die Messung durchgeführt werden soll, gekommen ist, und
Speichern des Ergebnisses der Messung in dem lokalen Puffer (24).

6. Verfahren nach Anspruch 5, bei dem die durch den Steuerbefehl spezifizierte Zeit relativ zu einem Zeitpunkt bestimmt wird, zu dem ein bestimmtes Ereignis auftritt.

7. Verfahren nach Anspruch 6, mit den weiteren Verfahrensschritten:
Erfassen des Zeitpunktes des Auftretens des bestimmten Ereignisses mit Hilfe einer lokalen, zur Realzeit synchronisierten Uhr (22) in einem dritten Meßgerät (18C), Übertragen des Zeitpunktes des Auftretens und
Durchführen der Messung, wenn die lokale Uhr (22) in dem Meßgerät (18A, 18B), welches die Messung durchführen soll, anzeigt, daß die Zeit, zu der die Messung durchgeführt werden soll und welche relativ zu dem Zeitpunkt des Auftretens des bestimmten Ereignisses bestimmt wird, gekommen ist.

8. Verfahren nach Anspruch 7, bei dem ferner die lokalen Uhren (22) in den Meßgeräten (18A, 18B, 18C) synchronisiert werden.

## Revendications

1. Système de mesure comportant un moyen de coordination (12) et plusieurs instruments de mesure (18A, 18B) distants les uns des autres et du moyen de coordination (12), le moyen de coordination (12) fonctionnant en transmettant des instructions de commande à plusieurs des instruments de mesure (18A, 18B), les instruments de mesure (18A, 18B) répondant aux instructions de commande en effectuant des mesures sur un dispositif (28) en cours de test, et en transmettant les résultats de ces mesures au moyen de coordination (12), caractérisé par:
une horloge locale synchronisée en temps réel (22) située dans chacun des instruments de mesure (18A, 18B), destinée à délivrer un signal de minutage ;
un tampon local (24) situé dans chacun des instruments de mesure (18A, 18B), destiné à stocker les instructions de commande respectives et les résultats de mesure;
un circuit de fonction d'instrument local (20) situé dans chacun des instruments de mesure (18A, 18B), ledit circuit répondant à l'instruction de commande respective située dans le tampon local respectif (24) en effectuant la mesure spécifiée par l'instruction de commande lorsque l'horloge locale respective (22) active le circuit local (20) à une heure spécifiée par l'instruction de commande et en stockant le résultat de la mesure dans le tampon local respectif (24).

2. Système selon la revendication 1, dans lequel l'heure spécifiée par l'instruction de commande est déterminée par rapport à une heure à laquelle un évènement spécifié se produit.

3. Système selon la revendication 2 et comportant en outre un troisième instrument de mesure (18C) ayant une horloge locale synchronisée en temps réel (22), le troisième instrument de mesure (18C) fonctionnant en détectant l'apparition de l'évènement spécifié, et en transmettant l'heure de l'apparition, telle qu'elle est indiquée par son horloge locale, aux autres instruments de mesure (18A, 18B), au moins l'un desdits autres instruments de mesure (18A, 18B) fonctionnant en exécutant la mesure spécifiée par l'instruction de commande, lorsque l'horloge locale respective (22) indique que l'heure spécifiée, telle qu'elle est déterminée par rapport à l'heure d'apparition de l'évènement spécifié, est proche.

4. Système selon la revendication 3 et comportant en outre un moyen (34) pour synchroniser les horloges locales (22).

5. Procédé de commande d'instruments de mesure (18A, 18B) dans un système comportant un moyen de coordination (12) qui transmet des instructions de commande à plusieurs desdits instruments de mesure (18A, 18B), distants les uns des autres et du moyen de coordination (12), chacun des instruments de mesure (18A, 18B) répondant aux instructions de commande, en effectuant des mesures sur un dispositif (28) en cours de test et en transmettant les résultats de ces mesures au moyen de coordination (12), caractérisé par:
la transmission depuis le moyen de coordination (12) d'une instruction de commande qui spécifie une mesure à effectuer et une heure à laquelle la mesure doit être effectuée;
le stockage de l'instruction de commande dans un tampon local (24) situé dans l'instrument de mesure (18A, 18B) qui est destiné à effectuer la mesure;
l'exécution de la mesure spécifiée par l'instruction de commande lorsqu'une horloge synchronisée en temps réel (22) située dans l'instrument de mesure (18A, 18B) qui est destiné à effectuer la mesure, indique que l'heure à laquelle la mesure doit être effectuée est proche; et
le stockage du résultat de la mesure dans ledit tampon local (24).

6. Procédé selon la revendication 5, dans lequel l'heure spécifiée par l'instruction de commande est déterminée par rapport à une heure à laquelle un évènement spécifié se produit.

7. Procédé selon la revendication 6 comportant en outre:
la détection de l'heure d'apparition de l'évènement spécifié au moyen d'une horloge locale synchronisée en temps réel (22) située dans un troisième instrument de mesure (18C);
la transmission de ladite heure d'apparition; et
l'exécution de la mesure lorsque l'horloge locale (22) située dans l'instrument de mesure (18A, 18B) qui est destiné à effectuer la mesure indique que l'heure à laquelle la mesure doit être effectuée, telle qu'elle est déterminée par rapport à l'heure d'apparition de l'évènement spécifié, est proche.

8. Procédé selon la revendication 7 et comportant en outre la synchronisation des horloges locales (22) situées dans les instruments de mesure (18A, 18B, 18C).
